# EUROPEAN PATENT APPLICATION

(11) **EP 4 839 033 A1**
(43) Date of publication of application: **11.11.2026**
(21) Application number: 26175920.3
(22) Date of filing: 30.04.2026
(51) Int. Cl.: H05K 7/14, H05K 7/20

(54) **CARD GUIDE FADEC SUB ASSEMBLIES**

(30) Priority: 30.04.2025 US 202563797594 P
(71) Applicant: Hamilton Sundstrand Corporation, Charlotte, NC 28217-4578 (US)
(72) Inventor: SISSON, Jack, Moultonboroug, NH, 03254 (US); KELLY, Myles, Coventry, 06238 (US)
(74) Representative: Dehns

(57) **Abstract**

A support structure for an electronic engine control assembly includes a computer-card frame (116) with a top wall (122) and a bottom wall (120) facing the top wall. The computer-card frame also includes a first side wall (124) extending from the top wall to the bottom wall, and a second side wall (126) extending from the top wall to the bottom wall and facing the first side wall. A card compartment (132) is between the first side wall and the second side wall, and between the top wall and the bottom wall. A first plurality of card guides (136) is on the bottom wall and within the card compartment. A second plurality of card guides (140) is on the top wall and within the card compartment.

## Description

### CROSS-REFERENCE TO RELATED APPLICATION(S)

The present application claims priority to U.S. Provisional Patent Application No. 63/797,594 filed on April 30, 2025.

### BACKGROUND

The present disclosure is directed to electronic engine controllers and, more specifically, to Full Authority Digital Engine Controllers (FADEC).

FADECs are electronic engine controllers that control aircraft engine performance. A FADEC generally includes multiple computer cards disposed within a housing. In tight design envelopes where space and weight are constrained, FADEC housings can include a complex geometry with card guides for supporting the computer cards of the FADEC and cooling passages for fluid cooling the FADEC.

A complex manufacturing process is required to produce these FADEC housings with card guides and cooling passages. This manufacturing process can include machining steps, followed with a brazing operation, with more machining steps following the brazing operation. Due to the brazing operation, only a relatively small number of suppliers are certified to produce the FADEC housing, which can drive up the cost of the FADEC housing and increase the lead time for producing the FADEC housing. To improve manufacturing yield and lower cost, the tolerances on the geometry of the FADEC housing are loosened, which results in the FADEC housing having a larger envelope and larger performance considerations with cooling than otherwise desired.

### SUMMARY

In one example of the disclosure, an electronic engine control assembly includes a housing and a frame installed in the housing. The frame includes a top wall and a bottom wall facing the top wall. The frame also includes a first side wall extending from the top wall to the bottom wall, and a second side wall extending from the top wall to the bottom wall and facing the first side wall. A card compartment is between the first side wall and the second side wall, and between the top wall and the bottom wall. A first plurality of card guides is on the bottom wall and within the card compartment. A second plurality of card guides is on the top wall and within the card compartment.

In another example of the disclosure, a support structure for an electronic engine control assembly includes a computer-card frame with a top wall and a bottom wall facing the top wall. The computer-card frame also includes a first side wall extending from the top wall to the bottom wall, and a second side wall extending from the top wall to the bottom wall and facing the first side wall. A card compartment is between the first side wall and the second side wall, and between the top wall and the bottom wall. A first plurality of card guides is on the bottom wall and within the card compartment. A second plurality of card guides is on the top wall and within the card compartment.

In another example of the disclosure, a method of assembling an electronic engine control assembly includes installing a computer card of the electronic engine control assembly into a card guide formed in a sub-frame to form a sub-assembly of the electronic engine control assembly. The sub-assembly is placed within a housing of the electronic engine control assembly, and the sub-frame is installed to the housing.

### BRIEF DESCRIPTION OF THE DRAWINGS

FIG. 1A is a perspective view of an electronic engine control assembly.
FIG. 1B is an exploded perspective view of the electronic engine control assembly from FIG. 1A.
FIG. 2 is a perspective view of a sub-frame of the electronic engine control assembly.

### DETAILED DESCRIPTION

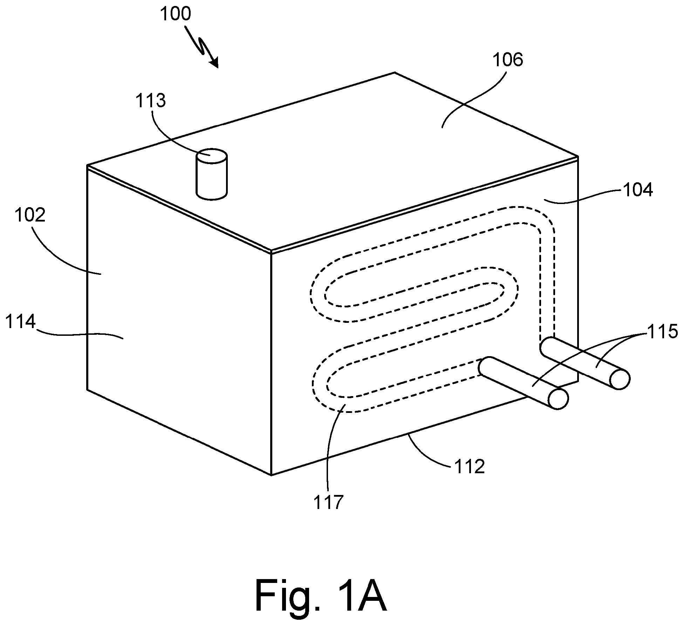

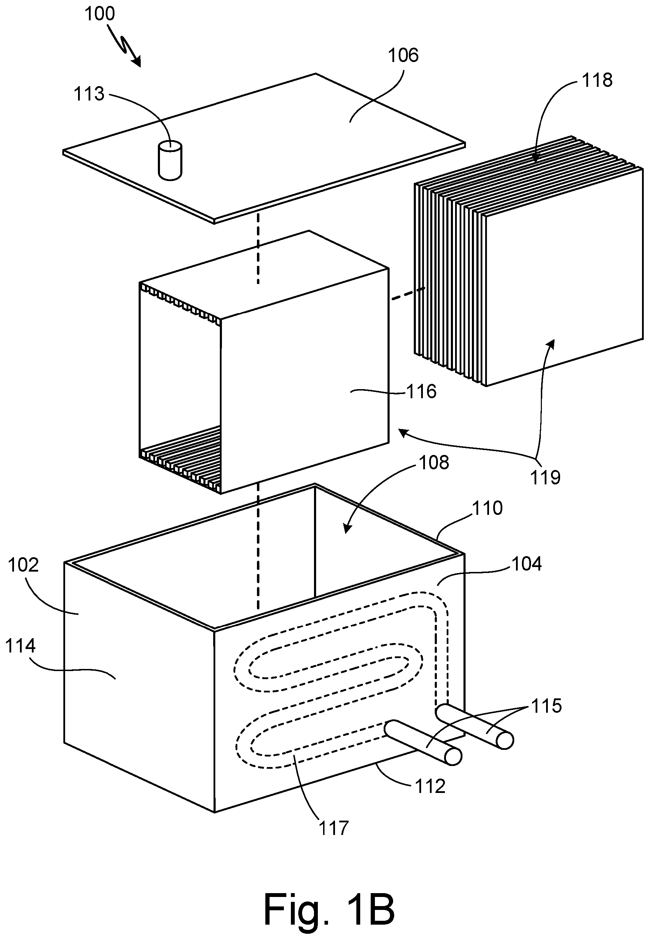

FIGS. 1A and 1B will be discussed concurrently. FIG. 1A is a perspective view of electronic engine control assembly 100 with housing 102. FIG. 1B is an exploded perspective view of the example of electronic engine control assembly 100 from FIG. 1A. As shown in the examples of FIGS. 1A and 1B, housing 102 of electronic engine control assembly 100 includes box 104 and cover 106. Box 104 includes opening 108, top edge 110, bottom side 112, side walls 114, hydraulic connectors 115, and fluid passage 117. Cover includes electrical connector 113. Electronic engine control assembly 100 also includes sub-frame 116, and a plurality of computer cards 118. Sub-frame 116 and computer cards 118 can together form sub-assembly 119. Electonic engine control assembly 100 can be a Full Authority Digital Engine Controller (FADEC) for an aircraft engine.

In the example of FIGS. 1A and 1B, box 104 of housing 102 includes four side walls 114 connected to bottom side 112 and extending from bottom side 112 to top edge 110. The four side walls 114 and top edge 110 form opening 108 of box 104. When housing 102 is assembled together, cover 106 is connected to top edge 110 of box 104 and extends over opening 108 to close and seal housing 102. Cover 106 can be removably connected to box 104 to allow easy reopening of housing 102 for maintenance and repair of electronic engine control assembly 100. For example, cover 106 can be bolted to box 104 by threaded fasteners (not shown), such as bolts, screws, and/or nuts. In other examples, cover 106 can be connected to box 104 by non-threaded fasteners, such as clamps, rivets, or lock, or any other fastener capable of connecting cover 106 to box 104. In the example of FIGS. 1A and 1B, cover 106 is the only cover needed to close housing 102. In other examples, housing 102 can include multiple covers 106.

Box 104 and/or cover 106 can include at least one electrical connector 113 (or electrical port) to allow electrical cables and wiring to plug into and electrically connect with electronic engine control assembly 100. In the example of FIGS. 1A and 1B, the at least one electrical connector is part of cover 106, but in other examples, the at least one electrical connector 113 can be connected to one of side walls 114 of box 104. Box 104 and/or cover 106 can include at least two hydraulic connectors 115 to allow hydraulic cooling lines to be connected to housing 102. In the example of FIGS. 1A and 1B, hydraulic connectors 115 are connected to one of side walls 114 of box 104, but in other examples hydraulic connectors 115 can be part of cover 106. Fluid passage 117, shown in phantom in FIGS. 1A and 1B, is formed within at least one of side walls 114 so that cooling fluid (such as fuel, engine oil, or any other suitable cooling liquid) can circulate within at least one of side walls 114 of housing 102 to cool electronic engine control assembly 100. In other examples, fluid passage(s) 117 can be formed within bottom side 112 of box 104, and/or within cover 106. Fluid passage 117 in housing 102 can be fluidically connected to the at least two hydraulic connectors 115 so that the at least two hydraulic connectors 115 can fluidically connect fluid passage 117 to a cooling supply line and a cooling return line of a cooling system. In other examples, fluid cooling lines can be formed separate from box 104, can be installed inside of box 104, and can be fluidically connected to the at least two hydraulic connectors 115 of housing 102.

Side walls 114 and bottom side 112 of box 104 can form a monolithic component formed from a single piece of stock material. For example, box 104 can be machined from a single piece of stock material, such as steel, aluminum, titanium, or any other material suitable to house and protect electronic engine control assembly 100. In other examples, box 104 can be additively manufactured. Cover 106 can also be machined from a single piece of stock material, such as steel, aluminum, titanium, or any other material suitable to house and protect electronic engine control assembly 100. In other examples, cover 106 can be additively manufactured.

Computer cards 118 of electronic engine control assembly 100 can each be a printed circuit board (PCB) that includes electronic components. The electronic components can include (but are not limited to) random-access memory (RAM), read-only memory (ROM), erasable programmable read-only memory (EPROM or Flash memory), static random access memory (SRAM), microprocessors, controllers, digital signal processors (DSP), application specific integrated circuits (ASIC), field-programmable gate arrays (FPGA), electronic connectors, electronic ports, analog-to-digital converters, digital-to-analog converters, capacitors, resistors, transistors, transformers, diodes, batteries, crystal oscillators, inductors, switches, sensors, potentiometers, and rectifiers. When electronic engine control assembly 100 is assembled, computer cards 118 of electronic engine control assembly 100 are installed within sub-frame 116.

As shown in the example of FIGS. 1A and 1B, sub-frame 116 is a separate component from housing 102. Sub-frame 116 can be a single-piece frame that receives and supports computer cards 118, and spaces computer cards 118 from each other. After computer cards 118 are installed in sub-frame 116, computer cards 118 and sub-frame 116 form sub-assembly 119 of electronic engine control assembly 100. Additional wiring can be added to sub-assembly 119 to electrically connect computer cards 118 to one another before sub-assembly 119 is installed within box 104 of housing 102. Adding wiring to computer cards 118 outside of housing 102 is convenient as the operator has more hand space to route the wiring and manipulate tools to connect the wiring to computer cards 118 before computer cards 118 and sub-frame 116 are both installed inside housing 102. Computer cards 118 can also be connected by wiring to electrical connectors 113 before computer cards 118 and sub-frame 116 are both installed inside housing 102.

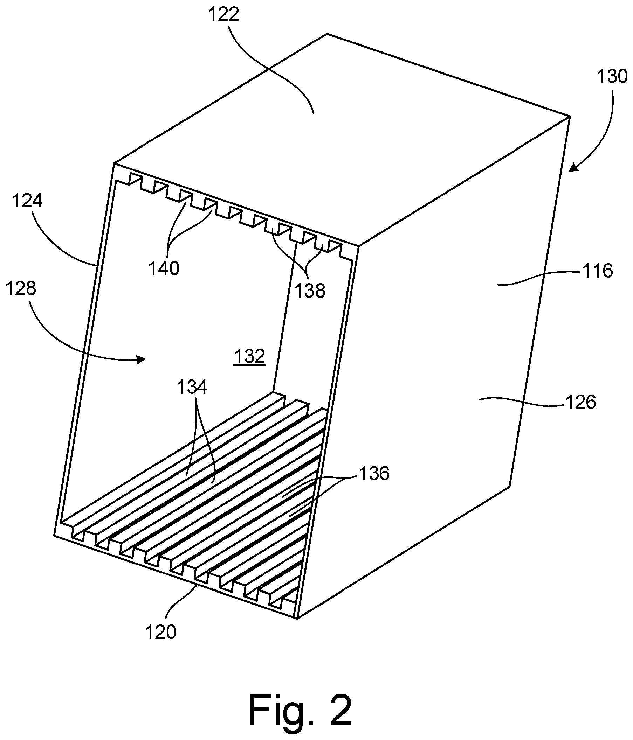

Once sub-frame 116 and computer cards 118 are assembled together into sub-assembly 119, sub-assembly 119 is passed through opening 108 of housing 102 and placed within box 104 of housing 102. After sub-assembly 119 is placed within box 104 of housing 102, sub-frame 116 is installed within housing 102 to connect sub-assembly 119 to housing 102. Sub-frame 102 can be removably connected to housing 102 by fasteners (not shown), such as bolts, screws, and/or clamps. In the example of FIGS. 1A and 1B, sub-frame 102 is removably connected to box 104. In other examples, sub-frame 102 can be removably connected to cover 106 before insertion into box 104. Sub-frame 116 securely supports and positions computer cards 118 inside of housing 102. Sub-frame 116 and housing 102 together form a support structure of electronic engine control assembly 100 that supports and protects the electronic components of electronic engine control assembly 100. After sub-frame 116 and computer cards 118 are secure within box 104, cover 106 can be connected over opening 108 to completely enclose sub-frame 116 and computer cards 118 inside of housing 102. Sub-frame 116 is discussed in greater detail below with reference to FIG. 2.

FIG. 2 is a perspective view of an example of sub-frame 116 of electronic engine control assembly 100. As shown in the example of FIG. 2, sub-frame 116 includes bottom wall 120, top wall 122, first side wall 124, second side wall 126, first open side 128, second open side 130, card compartment 132, first plurality of ribs 134, first plurality of grooves 136, second plurality of ribs 138, and second plurality of grooves 140.

Bottom wall 120 faces top wall 122, and first side wall 124 extends from top wall 122 to bottom wall 120. Second side wall 126 also extends from top wall 122 to bottom wall 120 and faces first side wall 124. First side wall 124 and second side wall 126 are both connected to top wall 122 and bottom wall 120 and space top wall 122 and bottom wall 120 apart. Card compartment 132 is between first side wall 124 and second side wall 126, and is also between top wall 122 and bottom wall 120. First open side 128 is between first side wall 124 and second side wall 126, and between top wall 122 and bottom wall 120. Second open side 130 is between first side wall 124 and second side wall 126, and between top wall 122 and bottom wall 120, and is opposite from first open side 128. First open side 128 and second open side 130 provide strait-through access to card compartment 132 so that computer cards 118 can be slid into and out of card compartment 132. First open side 128 and second open side 130 also allow heat to readily dissipate out of card compartment 132.

The first plurality of grooves 136 is formed into or on bottom wall 120 and is within card compartment 132. The first plurality of grooves 136 form the first plurality of ribs 134, with each rib 134 of the first plurality of ribs 134 disposed between two grooves 136 of the first plurality of grooves 136. Together, the first plurality of ribs 134 and the first plurality of grooves 136 can form a first plurality of card guides on bottom wall 120 and within card compartment 132. In the example of FIG. 2, the first plurality of ribs 134 and the first plurality of grooves 136 both extend a full depth of card compartment 132 from first open side 128 to second open side 130. In other examples, the first plurality of ribs 134 and the first plurality of grooves 136 extend only to first open side 128, but stop short of second open side 130 to form a card stop. In other examples, the first plurality of ribs 134 and the first plurality of grooves 136 extend only to second open side 130, but stop short of first open side 128 to form a card stop.

The second plurality of grooves 140 is formed into or on top wall 122 and is within card compartment 132. The second plurality of grooves 140 form the second plurality of ribs 138, with each rib 138 of the second plurality of ribs 138 disposed between two grooves 140 of the second plurality of grooves 140. Together, the second plurality of ribs 138 and the second plurality of grooves 140 can form a second plurality of card guides on top wall 122 and within card compartment 132. In the example of FIG. 2, the second plurality of ribs 138 and the second plurality of grooves 140 both extend a full depth of card compartment 132 from first open side 128 to second open side 130. In other examples, the second plurality of ribs 138 and the second plurality of grooves 140 extend only to first open side 128, but stop short of second open side 130 to form a card stop. In other examples, the second plurality of ribs 138 and the second plurality of grooves 140 extend only to second open side 130, but stop short of first open side 128 to form a card stop.

The first plurality of grooves 136 is aligned with the second plurality of grooves 140 across card compartment 132 such that each groove 136 of the first plurality of grooves 136 faces a corresponding groove 140 of the second plurality of grooves 140. When one of computer cards 118 is installed inside of card compartment 132 of sub-frame 116, the computer card 118 enters card compartment 132 through first open side 128 or second open side 130. A first end of the computer card 118 is received in one groove 136 of the first plurality of grooves 136, and a second end of the computer card 118 is received in one groove 140 of the second plurality of grooves 140. The computer card 118 can then slide in the groove 136 and the corresponding groove 140 until the computer card 118 is within sub-frame 116. Fasteners (such as clamps, screws, or bolts) can be included onto sub-frame 116 to lock the computer card 118 in place.

Sub-frame 116 can form a monolithic component formed from a single piece of stock material. For example, sub-frame 116 can be machined from a single piece of stock material, such as steel, aluminum, titanium, or any other material suitable to hold and support computer cards 118 in place within housing 102 of electronic engine control assembly 100. In some examples, sub-frame 116 can be formed from a plastic or composite material. In other examples, sub-frame 116 can be additively manufactured.

The electronic engine control assembly 100 disclosed herein provides numerous benefits and advantages. For example, if the electronics from electronic engine control assembly 100 require updating or repair, cover 106 can be removed from box 104 to open up housing 102, and sub-assembly 119 can be removed from housing 102. With sub-assembly 119 removed from housing 102, computer cards 118 can be removed from sub-frame 116 for replacement or repair. Once the repairs or replacements have been completed, computer cards 118 can be reinstalled into sub-frame 116, and sub-assembly 119 can be reinstalled into housing 102. This process is relatively fast as housing 102 does not have to be disconnected from an engine assembly or an aircraft for the maintenance to occur to computer cards 118. Any cooling lines or electrical lines connected to an exterior of housing 102 can remain connected to housing 102 during maintenance of computer cards 118.

Furthermore, electronic engine control assembly 100 can have a relative compact envelope with tighter manufacturing tolerances as computer cards 118 are assembled into sub-frame 116 outside of housing 102 before being mounted inside of housing 102. Thus, computer cards 118 can be installed within housing 102 with very little clearance. Smaller design envelopes and tighter manufacturing tolerances can improve cooling and performance of electronic engine control assembly 100. Assembling computer cards 118 into sub-frame 116 outside of housing 102 also provides easier hand and tool access to computer cards 118, which can lead to improved wire routing of electronic engine control assembly 100. Top access into box 104 of housing 102 can also lead to improved wire routing of electronic engine control assembly 100. Sub-assembly 119 advantageously reduces both overall external envelope and weight of electronic engine control assembly 100, while increasing the number of installation options for electronic engine control assembly 100.

Sub-frame 116 can also be made through relatively simply machining steps without any relatively expensive brazing steps. Also, if the electronics of electronic engine control assembly 100 undergo a significant update that affects the support structure for computer cards 118, sub-frame 116 (which is a relatively inexpensive part) can be replaced with an updated version of sub-frame 116, while the original housing 102 (which can be a relatively expensive part to manufacture due to internal cooling passages and hydraulic connections) can continue to be used in electronic engine control assembly 100. Thus, sub-frame 116 can reduce the obsolescence risk for electronic engine control assembly 100. The inclusion of sub-frame 116 can also decrease the complexity of housing 102 compared to previous FADEC housings, which can reduce the machining and brazing steps required to manufacture housing 102. Thus sub-frame 116 and housing 102 can reduce the overall cost and manufacturing lead time for electronic engine control assembly 100.

### Discussion of Possible Embodiments

The following are non-exclusive descriptions of possible embodiments of the present invention.

An electronic engine control assembly includes a housing and a frame installed in the housing. The frame includes a top wall and a bottom wall facing the top wall. The frame also includes a first side wall extending from the top wall to the bottom wall, and a second side wall extending from the top wall to the bottom wall and facing the first side wall. A card compartment is between the first side wall and the second side wall, and between the top wall and the bottom wall. A first plurality of card guides is on the bottom wall and within the card compartment. A second plurality of card guides is on the top wall and within the card compartment.

The electronic engine control assembly of the preceding paragraph can optionally include, additionally and/or alternatively, any one or more of the following features, configurations and/or additional components in the paragraphs below.

In an embodiment of the foregoing electronic engine control assembly, the electronic engine control assembly further comprises at least one computer card inside the card compartment of the frame and in one groove of the first plurality of grooves, and in one groove of the second plurality of grooves, and wherein the at least one computer card and the frame form a subassembly that is removably connected to the housing

In an embodiment of the foregoing electronic engine control assembly, the housing comprises a box with an opening; and a cover connected to the box over the opening.

In an embodiment of the foregoing electronic engine control assembly, the first plurality of card guides comprises a first plurality of grooves formed in the bottom wall and within the card compartment.

In an embodiment of the foregoing electronic engine control assembly, the second plurality of card guides comprises a second plurality of grooves formed in the top wall within the card compartment.

In an embodiment of the foregoing electronic engine control assembly, the first plurality of grooves is aligned with the second plurality of grooves.

In an embodiment of the foregoing electronic engine control assembly, the frame comprises: a first open side between the first side wall and the second side wall, and between the top wall and the bottom wall; and a second open side between the first side wall and the second side wall, and between the top wall and the bottom wall, and opposite the first open side.

In an embodiment of the foregoing electronic engine control assembly, the first plurality of grooves extends to the first open side, and wherein the second plurality of grooves extends to the first open side.

In an embodiment of the foregoing electronic engine control assembly, the first plurality of grooves extends to the second open side, and wherein the second plurality of grooves extends to the second open side.

In another example of the disclosure, a support structure for an electronic engine control assembly includes a computer-card frame with a top wall and a bottom wall facing the top wall. The computer-card frame also includes a first side wall extending from the top wall to the bottom wall, and a second side wall extending from the top wall to the bottom wall and facing the first side wall. A card compartment is between the first side wall and the second side wall, and between the top wall and the bottom wall. A first plurality of card guides is on the bottom wall and within the card compartment. A second plurality of card guides is on the top wall and within the card compartment.

The support structure of the preceding paragraph can optionally include, additionally and/or alternatively, any one or more of the following features, configurations and/or additional components in the paragraphs below.

In an embodiment of the foregoing support structure, the first plurality of card guides includes a first plurality of grooves formed on the bottom wall and within the card compartment.

In an embodiment of the foregoing support structure, the second plurality of card guides includes a second plurality of grooves formed on the top wall within the card compartment.

In an embodiment of the foregoing support structure, the first plurality of grooves is aligned with the second plurality of grooves.

In an embodiment of the foregoing support structure, the computer card-frame comprises: a first open side between the first side wall and the second side wall, and between the top wall and the bottom wall; and a second open side between the first side wall and the second side wall, and between the top wall and the bottom wall, and opposite the first open side.

In an embodiment of the foregoing support structure, the first plurality of card guides extends to the first open side, and wherein the second plurality of card guides extends to the first open side.

In an embodiment of the foregoing support structure, the first plurality of card guides extends to the second open side, and wherein the second plurality of card guides extends to the second open side.

In an embodiment of the foregoing support structure, the support structure further includes a housing, and wherein the support structure is removably mounted within the housing.

In an embodiment of the foregoing support structure, the housing comprises a box with an opening; and a cover connected to the box over the opening.

In another example of the disclosure, a method of assembling an electronic engine control assembly includes installing a computer card of the electronic engine control assembly into a card guide formed in a sub-frame to form a sub-assembly of the electronic engine control assembly. The sub-assembly is placed within a housing of the electronic engine control assembly, and the sub-frame is installed to the housing.

The method of the preceding paragraph can optionally include, additionally and/or alternatively, any one or more of the following features, configurations and/or additional components in the paragraphs below.

In an embodiment of the foregoing method, the method further includes attaching a cover to the housing over the opening to close the opening.

While the invention has been described with reference to an exemplary embodiment(s), it will be understood by those skilled in the art that various changes may be made without departing from the scope of the invention as defined by the claims. For example, while electronic engine control assembly 100 has been described above with reference to FADECs, electronic engine control assembly 100 can also be used as fuel system controllers, actuator controllers, or any other electronic controller where envelope size and weight is constrained. In addition, many modifications may be made to adapt a particular situation or material to the teachings of the invention without departing from the essential scope thereof. For example, while the example of FIGS. 1A and 1B show housing 102 as a rectangular box housing, housing 102 can be any shape required by the design envelope of electronic engine control assembly 100. For example, housing 102 can be cylindrical, spheroidal, or a complex box. Therefore, it is intended that the invention not be limited to the particular embodiment(s) disclosed, but that the invention will include all embodiments falling within the scope of the appended claims.

## Claims

1. An electronic engine control assembly comprises:
a housing (102); and
a frame (116) installed in the housing, wherein the frame comprises:
a top wall (122);
a bottom wall (120) facing the top wall;
a first side wall (124) extending from the top wall to the bottom wall;
a second side wall (126) extending from the top wall to the bottom wall and facing the first side wall;
a card compartment (132) between the first side wall and the second side wall, and between the top wall and the bottom wall;
a first plurality of card guides (136) on the bottom wall and within the card compartment; and
a second plurality of card guides (140) on the top wall and within the card compartment.

2. The electronic engine control assembly of claim 1, further comprising:
at least one computer card (118) inside the card compartment of the frame and in one card guide of the first plurality of card guides, and in one card guide of the second plurality of card guides, and
wherein the at least one computer card and the frame form a subassembly that is removably connected to the housing.

3. The electronic engine control assembly of claim 1 or 2, wherein the housing comprises:
a box (104) with an opening (108); and
a cover (106) connected to the box over the opening.

4. A support structure for an electronic engine control assembly comprises:
a computer-card frame (116) comprising:
a top wall (122);
a bottom wall (120) facing the top wall;
a first side wall (124) extending from the top wall to the bottom wall;
a second side wall (126) extending from the top wall to the bottom wall and facing the first side wall;
a card compartment (132) between the first side wall and the second side wall, and between the top wall and the bottom wall;
a first plurality of card guides (136) on the bottom wall and within the card compartment; and
a second plurality of card guides (140) on the top wall and within the card compartment.

5. The electronic engine control assembly of any of claims 1 to 3 or the support structure of claim 4, wherein the first plurality of card guides comprises:
a first plurality of grooves formed on the bottom wall and within the card compartment.

6. The electronic engine control assembly or support structure of claim 5, wherein the second plurality of card guides comprises:
a second plurality of grooves formed on the top wall within the card compartment.

7. The electronic engine control assembly or support structure of claim 6, wherein the first plurality of grooves is aligned with the second plurality of grooves.

8. The electronic engine control assembly or support structure of any preceding claim, wherein the computer card-frame comprises:
a first open side (128) between the first side wall and the second side wall, and between the top wall and the bottom wall; and
a second open side (130) between the first side wall and the second side wall, and between the top wall and the bottom wall, and opposite the first open side.

9. The electronic engine control assembly or support structure of claim 8, wherein the first plurality of card guides extends to the first open side, and wherein the second plurality of card guides extends to the first open side.

10. The electronic engine control assembly or support structure of claim 9, wherein the first plurality of card guides extends to the second open side, and wherein the second plurality of card guides extends to the second open side.

11. The support structure of claim 4 or any claim dependent thereon, further comprising:
a housing (102), wherein the support structure is removably mounted within the housing.

12. The support structure of claim 11, wherein the housing comprises:
a box (104) with an opening (108); and
a cover (106) connected to the box over the opening.

13. A method of assembling an electronic engine control assembly comprises:
installing a computer card (118) of the electronic engine control assembly into a card guide (136, 140) formed in a sub-frame (116) to form a sub-assembly of the electronic engine control assembly;
placing the sub-assembly within a housing (102) of the electronic engine control assembly; and
installing the sub-frame to the housing.

14. The method of claim 13, further comprising:
attaching a cover (106) to the housing over an opening (108) of the housing to close the opening.
